# EUROPEAN PATENT APPLICATION

(11) **EP 4 468 360 A1**
(43) Date of publication of application: **27.11.2024**
(21) Application number: 22951454.2
(22) Date of filing: 19.07.2022
(51) Int. Cl.: H01L 27/15, H01L 33/00

(54) **DISPLAY APPARATUS, AND DISPLAY PANEL AND PREPARATION METHOD THEREFOR**

(71) Applicant: Boe Technology Group Co., Ltd., Beijing 100015 (CN)
(72) Inventor: WANG, Can, Beijing 100176 (CN); CHEN, Xiaochuan, Beijing 100176 (CN); XUAN, Minghua, Beijing 100176 (CN); ZHANG, Can, Beijing 100176 (CN); CONG, Ning, Beijing 100176 (CN); NIU, Jinfei, Beijing 100176 (CN); ZHANG, Jingjing, Beijing 100176 (CN)
(74) Representative: Lavoix
(86) International application number: PCT/CN2022/106562
(87) International publication number: WO 2024/016176

(57) **Abstract**

The present disclosure provides a display apparatus, a display panel and a method of preparing the same. A display panel includes: a base substrate; and a plurality of light-emitting units provided on the base substrate, where each of the light-emitting units includes a first electrode, a first semiconductor layer, a light-emitting layer, a second semiconductor layer, and a second electrode which are stacked, the first electrode is provided on a side of the second electrode facing away from the base substrate, and the plurality of light-emitting units share a common first electrode. The present disclosure can improve display resolution.

## Description

### TECHNICAL FIELD

The present disclosure relates to the field of display technology, and in particular to a display apparatus, a display panel and a method of preparing the same.

### BACKGROUND

With the development of science and technology, display technology has attracted more and more attention. Conventional display apparatuses have low display resolution.

### SUMMARY

An object of the present disclosure is to provide a display apparatus, a display panel and a method of preparing the same, which can improve display resolution.

According to an aspect of the present disclosure, there is provided a display panel including:
a base substrate; and
a plurality of light-emitting units provided on the base substrate, where each of the light-emitting units includes a first electrode, a first semiconductor layer, a light-emitting layer, a second semiconductor layer, and a second electrode which are stacked, the first electrode is provided on a side of the second electrode facing away from the base substrate, and the plurality of light-emitting units share a common first electrode.

Further, the display panel further includes:
an isolation structure, at least part of the isolation structure being located between adjacent two of the light-emitting units, and a surface of the isolation structure facing away from the base substrate being further away than a surface of each light-emitting layer facing away from the base substrate in a thickness direction of the base substrate.

Further, the isolation structure is provided on the base substrate and includes a plurality of openings; the plurality of light-emitting units are provided one-to-one in the plurality of openings; and the first electrode is provided on a side of the isolation structure facing away from the base substrate.

Further, the first semiconductor layers of the plurality of light-emitting units are arranged in a same layer and are of a monolithic structure, and the first semiconductor layers are provided on the surface of the isolation structure facing away from the base substrate.

Further, a refractive index of the isolation structure is the same as that of the first semiconductor layers.

Further, a spacing area is between portions of adj acent two of the light-emitting units other than the first electrode, and a recess is formed in a portion of the first electrode corresponding to the spacing area; and the isolation structure is provided on a side of the first electrode facing away from the base substrate, and located in the recess.

Further, the isolation structure includes a retro-reflective material.

Further, the second electrode is bonded to the base substrate via a metal bonding layer.

Further, the display panel further includes:
a light extraction structure provided on a light-exiting side of the light-emitting layer.

Further, a surface of the first electrode facing away from the base substrate is a roughened surface that forms the light extraction structure; or
a surface of the first semiconductor layer facing away from the second semiconductor layer is a roughened surface that forms the light extraction structure.

Further, the display panel further includes:
a light condenser unit provided on the first electrode in an area corresponding to the light-emitting layer.

Further, a surface of the light condenser unit facing away from the first electrode is a curved surface, and protrudes towards a direction away from the base substrate.

Further, the first semiconductor layers include a common film layer and a plurality of protrusions, where the plurality of protrusions are provided one-to-one on surfaces of the light-emitting layers of the plurality of light-emitting units facing away from the second semiconductor layer, and the common film layer is provided on a side of the plurality of protrusions facing away from the second semiconductor layer.

Further, a ratio of a thickness of each of the protrusions to a thickness of the common film layer is 1/4 to 1/2.

Further, the display panel further includes:
a metal grid provided on a side of the first electrode facing away from the base substrate and connected with the first electrode, where an orthographic projection of each light-emitting layer onto the base substrate is located within an area of an orthographic projection of a respective hole of the metal grid onto the base substrate.

Further, the display panel includes a display area and a peripheral area surrounding the display area, the plurality of light-emitting units being located in the display area, and the display panel further includes:
a connecting wire provided on the base substrate and located in the peripheral area, where the metal grid is electrically connected with the connecting wire.

Further, the base substrate is a silicon-based substrate.

According to an aspect of the present disclosure, there is provided a method of preparing a display panel, including:
providing a base substrate; and
forming a plurality of light-emitting units on the base substrate, where each of the light-emitting units includes a first electrode, a first semiconductor layer, a light-emitting layer, a second semiconductor layer, and a second electrode which are stacked, the first electrode is provided on a side of the second electrode facing away from the base substrate, and the plurality of light-emitting units share a common first electrode.

Further, the method further includes:
forming an isolation structure, where at least part of the isolation structure is located between adjacent two of the light-emitting units, and a surface of the isolation structure facing away from the base substrate is further away than a surface of each light-emitting layer facing away from the base substrate in a thickness direction of the base substrate.

Further, the isolation structure is provided on the base substrate and includes a plurality of openings; the plurality of light-emitting units are provided one-to-one in the plurality of openings; and the first electrode is formed on a side of the isolation structure facing away from the base substrate.

Further, forming the plurality of light-emitting units on the base substrate includes:
sequentially forming the first semiconductor layer, the light-emitting layer, and the second semiconductor layer on a support plate;
forming a first etching trench and a plurality of first retention units arranged at intervals by a patterning process, where the first etching trench is disposed around the first retention units, and a distance between a bottom surface of the first etching trench and the support plate is less than or equal to a thickness of the first semiconductor layer;
bonding the first retention units and the base substrate via a metal bonding layer that forms the second electrode, and removing the support plate; and
forming the first electrode.

Further, the distance between the bottom surface of the first etching trench and the support plate is greater than zero and less than the thickness of the first semiconductor layer, the first semiconductor layers include a common film layer and a plurality of protrusions, where the plurality of protrusions are provided one-to-one on surfaces of the light-emitting layers of the plurality of light-emitting units facing away from the second semiconductor layer, and the common film layer is provided on a side of the plurality of protrusions facing away from the second semiconductor layer.

Further, forming the plurality of light-emitting units on the base substrate includes:
sequentially forming the first semiconductor layer, the light-emitting layer, and the second semiconductor layer on a support plate;
bonding the second semiconductor layer and the base substrate via a metal bonding layer that forms the second electrode;
removing the support plate and forming a second etching trench and a plurality of second retention units arranged at intervals by a patterning process, where the second etching trench is disposed around the second retention units, and a bottom surface of the second etching trench is the base substrate; and
forming the first electrode.

According to an aspect of the present disclosure, there is provided a display apparatus including the display panel.

With the display apparatus, the display panel and the method of preparing the same according to the present disclosure, a light-emitting unit includes a first electrode, a first semiconductor layer, a light-emitting layer, a second semiconductor layer, and a second electrode which are stacked, that is, the light-emitting unit is of a vertical structure, such that the number of light-emitting units on the base substrate can be increased, and in turn the display resolution of the display panel can be improved. Moreover, since a plurality of light-emitting units share a common first electrode, the preparation process can be simplified.

### BRIEF DESCRIPTION OF DRAWINGS

FIG. 1 is a schematic diagram illustrating a base substrate according to an embodiment of the present disclosure.
FIG. 2 is a schematic diagram after step S1101A and step S1101B in a method of preparing a display panel according to an embodiment of the present disclosure.
FIG. 3 is a schematic diagram after step S1 102A in a method of preparing a display panel according to an embodiment of the present disclosure.
FIG. 4 is a schematic diagram after bonding first retention units and a base substrate via a metal bonding layer in a method of preparing a display panel according to an embodiment of the present disclosure.
FIG. 5 is a schematic diagram after forming a first semiconductor layer with a roughened surface in a method of preparing a display panel according to an embodiment of the present disclosure.
FIG. 6 is a schematic diagram after forming an isolation structure in a structure shown in FIG. 5.
FIG. 7 is a schematic diagram after forming a first electrode and a metal grid in a structure shown in FIG. 6.
FIG. 8 is a schematic diagram after step S1102B in a method of preparing a display panel according to an embodiment of the present disclosure.
FIG. 9 is a schematic diagram after step S1103B in a method of preparing a display panel according to an embodiment of the present disclosure.
FIG. 10 is a plan view of a structure shown in FIG. 9.
FIG. 11 is a schematic diagram after forming a roughened surface in a structure shown in FIG. 9.
FIG. 12 is a schematic diagram after forming an isolation structure in a structure shown in FIG. 11.
FIG. 13 is a schematic diagram after forming a first electrode and a metal grid in a structure shown in FIG. 12.
FIG. 14 is a plan view of structures shown in FIGS. 7 and 13.
FIGS. 15 and 16 are schematic diagrams illustrating a display panel according to an embodiment of the present disclosure.

### Description of reference numerals

1: base substrate; 101: connection structure; 2: light-emitting unit; 201: first electrode; 202: first semiconductor layer; 2021: common film layer; 2022: protrusion; 203: light-emitting layer; 204: second semiconductor layer; 205: second electrode; 3: isolation structure; 4: metal grid; 5: support plate; 6: roughened surface; 7: light extraction structure; 8: connecting wire; 9: insulating layer; 10: light condenser unit; 11: first etching trench; 12: first retention unit; 13: second etching trench; 14: second retention unit; 15: metal bonding layer; 100: display area; 200: peripheral area.

### DETAILED DESCRIPTION

Reference will now be made in detail to exemplary embodiments, examples of which are illustrated in the accompanying drawings. When the following description refers to the drawings, the same numerals in different drawings indicate the same or similar elements, unless otherwise indicated. Embodiments described in the following exemplary embodiments are not intended to represent all embodiments consistent with the present disclosure. Rather, they are merely examples of apparatuses consistent with some aspects of the present disclosure as detailed in the appended claims.

Terminology used in the present disclosure is for the purpose of describing particular embodiments only and is not intended to be limiting of the present disclosure. Unless otherwise defined, technical or scientific terms used in the present disclosure shall have their ordinary meanings as understood by a person of ordinary skill in the art to which the present disclosure pertains. Terms "first," "second," and the like as used in the specification and claims of the present disclosure do not imply any order, quantity, or importance, but are merely used to distinguish one component from another. Similarly, terms "a" or "an" and the like do not denote a limitation on quantity, but rather denote the presence of at least one. "A plurality of' or "several" means two or more. Unless otherwise indicated, terms "front," "rear," "lower," and/or "upper" and the like are for the purpose of illustration only and are not limited to one position or spatial orientation. Terms "including" or "comprising" and the like are intended to mean that elements or items preceding "including" or "comprising" are intended to encompass elements or items listed after "including" or "comprising," and equivalents thereof, and are not intended to exclude other elements or items. Terms "connected" or "coupled" and the like are not limited to physical or mechanical connections, but may include electrical connections, whether direct or indirect. As used in the specification of the present disclosure and the appended claims, the singular forms of "a," "an," "the," and "said" are intended to include plural forms as well, unless the context clearly dictates otherwise. It should also be understood that the term "and/or" as used herein refers to and encompasses any or all possible combinations of one or more of the associated listed items.

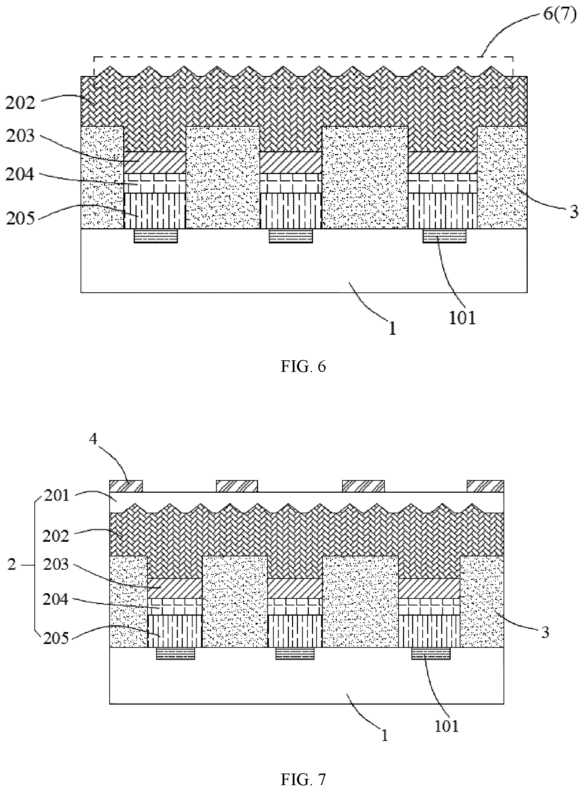

Embodiments of the present disclosure provide a display panel. As shown in FIGS. 7, 13, 15 and 16, the display panel may include a base substrate 1 and a plurality of light-emitting units 2.

The plurality of light-emitting units 2 are provided on the base substrate 1. Each of the light-emitting units 2 includes a first electrode 201, a first semiconductor layer 202, a light-emitting layer 203, a second semiconductor layer 204, and a second electrode 205 which are stacked. The first electrode 201 is located on a side of the second electrode 205 facing away from the base substrate 1. The plurality of light-emitting units 2 share a common first electrode 201.

With the display panel according to embodiments of the present disclosure, a light-emitting unit 2 includes a first electrode 201, a first semiconductor layer 202, a light-emitting layer 203, a second semiconductor layer 204, and a second electrode 205 which are stacked, that is, the light-emitting unit 2 is of a vertical structure. Compared to a light-emitting unit with a horizontal structure, the present disclosure can increase the number of light-emitting units 2 on the base substrate 1, and in turn improve the display resolution of the display panel. Moreover, since a plurality of light-emitting units share a common first electrode 201, the preparation process can be simplified.

Components of the display panel according to embodiments of the present disclosure will be described in detail below.

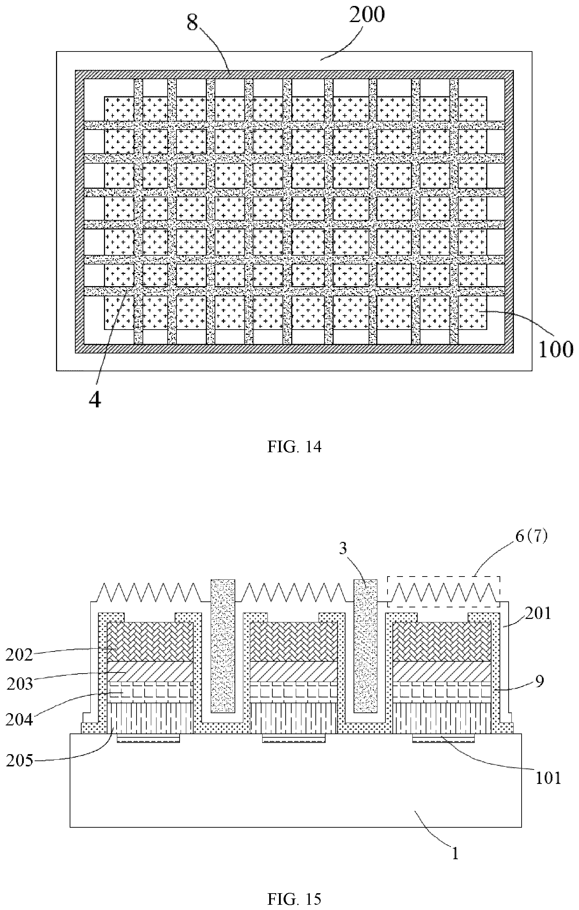

The base substrate 1 may be a glass substrate or, of course, a polyimide substrate. In other embodiments, the base substrate 1 may be a silicon-based substrate, which can improve the thermal conductivity and electrical conductivity of the base substrate 1 and facilitate the subsequent preparation of a plurality of film layers. Meanwhile, the silicon-based substrate has a low cost, which can also reduce the preparation cost. The base substrate 1 may be provided with a pixel driving circuit. The pixel driving circuit may include a driving transistor and a switching transistor connected to the driving transistor. The switching transistor may be a CMOS (Complementary Metal Oxide Semiconductor) transistor. The display panel may include a display area 100 and a peripheral area 200 surrounding the display area 100 (see FIG. 14). The pixel driving circuit as described above may be located in the display area 100. Furthermore, the base substrate 1 is provided with a connection structure 101 on a surface thereof. The connection structure 101 is electrically connected to a source or drain of the driving transistor.

The light-emitting unit 2 may be located in the display area 100 (see FIG. 14). The light-emitting unit 2 may be a light-emitting diode, or the like. The light-emitting unit 2 includes a first electrode 201, a first semiconductor layer 202, a light-emitting layer 203, a second semiconductor layer 204, and a second electrode 205 which are stacked. The first electrode 201 is located on a side of the second electrode 205 facing away from the base substrate 1. The second electrode 205 may be bonded to the base substrate 1, such that the second electrode 205 is electrically connected to the connection structure 101, and in turn electrically connected to the source or drain of the driving transistor. The second electrode 205 may be bonded to the base substrate 1 via a metal bonding layer. The first semiconductor layer 202 may have a different conductivity type than the second semiconductor layer 204. For example, the first semiconductor layer 202 is an n-type semiconductor layer and the second semiconductor layer 204 is a p-type semiconductor layer. For another example, the first semiconductor layer 202 is a p-type semiconductor layer and the second semiconductor layer 204 is an n-type semiconductor layer. Both the first semiconductor layer 202 and the second semiconductor layer 204 may include GaN. The light-emitting layer 203 may be a quantum well layer. In an embodiment, the first electrode 201 is a cathode and the second electrode 205 is an anode. In another embodiment, the first electrode 201 is an anode and the second electrode 205 is a cathode.

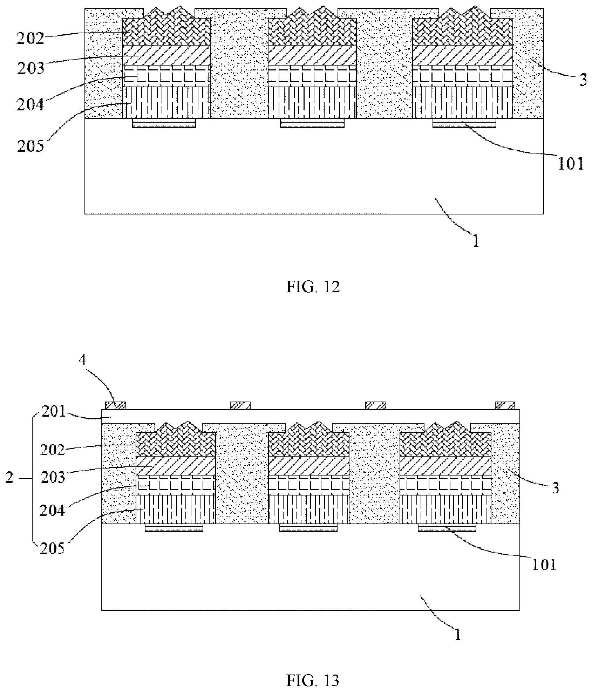

As shown in FIG. 7, second electrodes 205 of the plurality of light-emitting units 2 may be arranged at intervals. Second semiconductor layers 204 of the plurality of light-emitting units 2 may be arranged at intervals. Light-emitting layers 203 of the plurality of light-emitting units 2 may be arranged at intervals. First semiconductor layers 202 of the plurality of light-emitting units 2 may be arranged at intervals (see FIG. 13). However, the first semiconductor layers 202 of the plurality of light-emitting units 2 are arranged in the same layer and are of a monolithic structure (see FIG. 7), that is, the light-emitting layers 203 of the plurality of light-emitting units 2 are connected to a common first semiconductor layer 202, which can improve the uniformity of electric current in the first semiconductor layers 202 of the plurality of light-emitting units 2 after power on, and in turn improve the light-emitting uniformity of the plurality of light-emitting units 2. The plurality of light-emitting units 2 may share a common first electrode 201, that is, the first electrodes 201 of the plurality of light-emitting units 2 are arranged in the same layer and are of a monolithic structure.

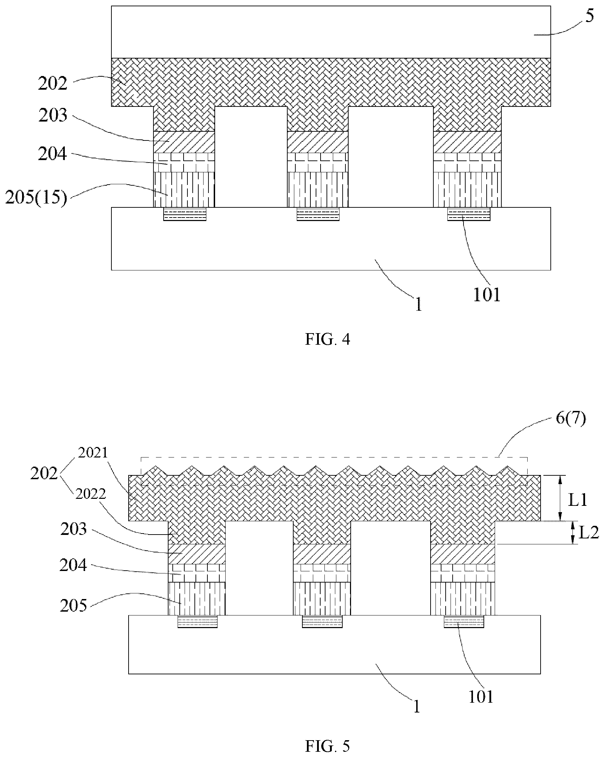

For example, in the case that the first semiconductor layers 202 of the plurality of light-emitting units 2 are arranged in the same layer and are of a monolithic structure, the first semiconductor layers 202 may include a common film layer 2021 and a plurality of protrusions 2022, as shown in FIG. 5. The plurality of protrusions 2022 are disposed one-to-one on surfaces of the light-emitting layers 203 facing away from the second semiconductor layers 204. The common film layer 2021 is disposed on a side of the plurality of protrusions 2022 facing away from the second semiconductor layers 204. A ratio of a thickness L2 of the protrusion 2022 to a thickness L1 of the common film layer 2021 may be 1/4 to 1/2. An orthographic projection of any one of the light-emitting layer 203, the second semiconductor layer 204, and the second electrode 205 onto the base substrate 1 has the same shape as and completely overlaps with an orthographic projection of the protrusion 2022 onto the base substrate 1. A shape of the orthographic projection of the light-emitting layer 203 onto the base substrate 1 may be a square, a rectangle, a circle, or the like. For example, in the case that the shape of the orthographic projection of the light-emitting layer 203 onto the base substrate 1 is a square, a side length of the square may be 5 µm, or the like.

As shown in FIG. 7, the display panel according to the present disclosure may further include an isolation structure 3. The isolation structure 3 and the light-emitting units 2 may be located on the same side of the base substrate 1. At least part of the isolation structure 3 is located between adjacent two of the light-emitting units 2. The isolation structure 3 may be disposed around each of the light-emitting units 2 so as to separate any two adjacent light-emitting units 2 from each other. In a thickness direction of the base substrate 1, a surface of the isolation structure 3 facing away from the base substrate 1 is further away than a surface of each light-emitting layer 203 facing away from the base substrate 1, that is to say, the surface of the isolation structure 3 facing away from the base substrate 1 is located on a side of the light-emitting layers 203 away from the base substrate 1. In this way, light crosstalk between adjacent two of the light-emitting layers 203 can be reduced through the isolation structure 3.

In an embodiment of the present disclosure, as shown in FIG. 7, the isolation structure 3 may be disposed on the base substrate 1 and include a plurality of openings. The plurality of light-emitting units 2 are disposed one-to-one in the plurality of openings, and the first electrode 201 shared by the plurality of light-emitting units 2 may be disposed on a side of the isolation structure 3 facing away from the base substrate 1. Further, in the case that the plurality of light-emitting units 2 share a common first semiconductor layer 202 for example, the first semiconductor layer 202 may also be disposed on the surface of the isolation structure 3 facing away from the base substrate 1. The isolation structure 3 may be made of a transparent colloidal material. A refractive index of the isolation structure 3 may be different from that of the first semiconductor layer 202. However, a refractive index of the isolation structure 3 may be the same as that of the first semiconductor layer 202. In this way, light loss due to the difference in the refractive index between the isolation structure 3 and the first semiconductor layer 202 can be reduced. For example, in the case that the refractive index of the isolation structure 3 is the same as that of the first semiconductor layer 202, the refractive index of the isolation structure 3 may be greater than or equal to 2. However, the isolation structure 3 may also include a retro-reflective material, that is, the isolation structure 3 is a retro-reflective structure to reflect light incident to the isolation structures 3. The retro-reflective material included in the isolation structure 3 may have a reflectivity greater than 60%. The retro-reflective material may be an epoxy resin material, such as white glue.

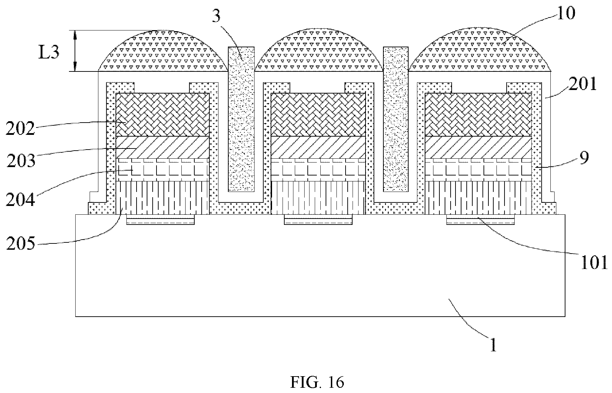

In another embodiment of the present disclosure, as shown in FIGS. 15 and 16, the first semiconductor layers 202 of the plurality of light-emitting units 2 may be arranged at intervals, the light-emitting layers 203 of the plurality of light-emitting units 2 may be arranged at intervals, the second semiconductor layers 204 of the plurality of light-emitting units 2 are arranged at intervals, and the second electrodes 205 of the plurality of light-emitting units 2 are arranged at intervals. That is, a spacing area is between portions of adjacent two of the light-emitting units 2 other than the first electrode 201. The first electrode 201 may extend into the spacing area, such that a recess is formed in a portion of the first electrode 201 corresponding to the spacing area. The isolation structure 3 may be provided on a side of the first electrode 201 facing away from the base substrate 1 and located in the recess. The isolation structure 3 may include a retro-reflective material, such as white glue. That is to say, the isolation structure 3 is a retro-reflective structure to reflect light incident to the isolation structure 3.

As shown in FIG. 15, the display panel according to the embodiment of the present disclosure may further include a light extraction structure 7. The light extraction structure 7 may be provided on a light-exiting side of the light-emitting layer 203. A surface of the first electrode 201 facing away from the base substrate 1 may be a roughened surface 6 which may form the light extraction structure 7. In this way, when light emitted from the light-emitting layer 203 arrives at the roughened surface 6, total reflection of the light can be reduced, and the reduced light extraction efficiency caused by the total reflection of the light can be solved. An area of the surface of the first electrode 201 facing away from the base substrate 1 corresponding to the light-emitting layer 203 may have a roughened surface 6, but is not limited thereto. An entire area of the surface of the first electrode 201 facing away from the base substrate 1 may have a roughened surface 6. As shown in FIG. 6 and FIG. 7, a surface of the first semiconductor layer 202 facing away from the second semiconductor layer 204 may also be a roughened surface 6 which forms a light extraction structure 7. In this way, when light emitted from the light-emitting layer 203 arrives at the roughened surface 6, total reflection of the light can be reduced, and the reduced light extraction efficiency caused by the total reflection of the light can be solved. An area of the surface of the first semiconductor layer 202 facing away from the second semiconductor layer 204 corresponding to the light-emitting layer 203 may have a roughened surface 6, but is not limited thereto. An entire area of the surface of the first semiconductor layer 202 facing away from the second semiconductor layer 204 may have a roughened surface 6.

As shown in FIG. 16, the display panel according to the embodiment of the present disclosure may further include a light condenser unit 10. The light condenser unit 10 may be provided on the first electrode 201 in an area corresponding to the light-emitting layer 203, and the light condenser unit 10 is configured to condense light emitted from the light-emitting layer 203. A surface of the light condenser unit 10 facing the first electrode 201 may be adhered to the first electrode 201, a surface of the light condenser unit 10 facing away from the first electrode 201 is a curved surface, and the surface of the light condenser unit 10 facing away from the first electrode 201 protrudes towards a direction away from the base substrate 1. A boundary of the surface of the light condenser unit 10 facing the first electrode 201 may be connected to a boundary of the surface of the light condenser unit 10 facing away from the first electrode 201. A shape of an orthographic projection of the light condenser unit 10 onto the base substrate 1 may be a circle, a diameter of which may be 5 µm, or the like. For example, in the case that the shape of the orthographic projection of the light-emitting layer 203 onto the base substrate 1 is a square, the diameter of the circular orthographic projection of the light condenser unit 10 onto the base substrate 1 may be the same as the side length of the orthographic projection of the light-emitting layer 203. The maximum thickness L3 of the light condenser unit 10 in the thickness direction of the base substrate 1 is 2.5µm, or the like.

As shown in FIG. 7, FIG. 13, and FIG. 14, the display panel according to the embodiment of the present disclosure may further include a metal grid 4. The metal grid 4 may be provided on a surface of the first electrode 201 facing away from the base substrate 1, that is, the metal grid 4 is connected to the first electrode 201. The orthographic projection of each light-emitting layer 203 onto the base substrate 1 is located within an area of an orthographic projection of a respective hole of the metal grid 4 onto the base substrate 1, that is, orthographic projections of grid lines of the metal grid 4 onto the base substrate 1 are spaced apart from orthographic projections of the light-emitting layers 203 onto the base substrate 1, such that not only a resistance of the first electrode 201 can be reduced and a voltage drop (IR drop) across the first electrode 201 can be reduced, but also the shading of light emitted from the light-emitting layer 203 by the metal grid 4 can be reduced due to the fact that an orthographic projection of the metal grid 4 onto the base substrate 1 is disposed around orthographic projections of the light-emitting layers 203 onto the base substrate 1. The metal grid 4 has a relatively low resistivity. The display panel according to the embodiment of the present disclosure may further include a connecting wire 8. The connecting wire 8 is provided on the base substrate 1 and may be located in the peripheral area 200 of the display panel. The connecting wire 8 may extend along the periphery of the display area 100 to surround the display area 100, i.e., the connecting wire 8 is in the shape of a ring. The metal grid 4 may be electrically connected to the connecting wire 8. For example, in the case that the first electrode 201 is a cathode, the connecting wire 8 may be a cathode ring.

The present disclosure further provides a method of preparing a display panel, which is used for preparing the display panel according to any one of the above embodiments. The method of preparing the display panel may include steps S100 to S110.

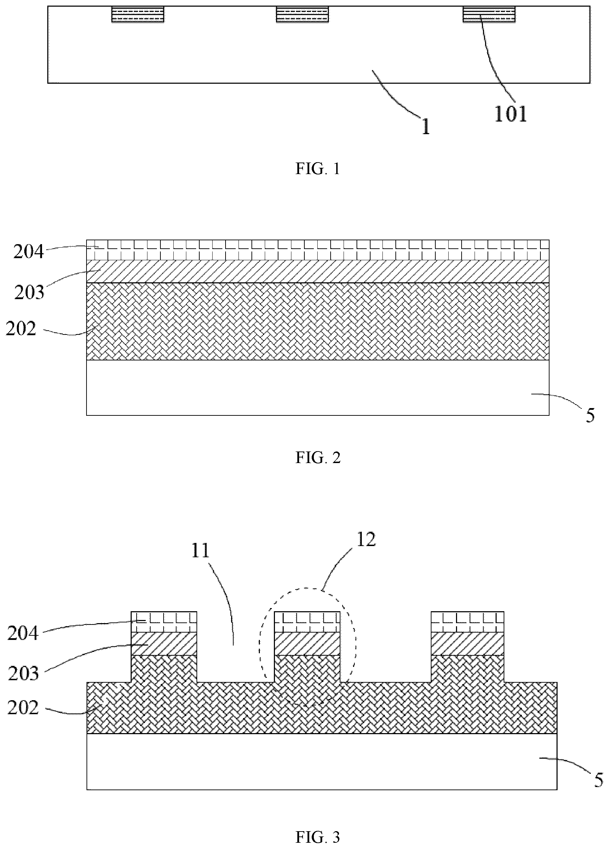

At step S100, as shown in FIG. 1, a base substrate 1 is provided.

At step S110, as shown in FIG. 7 and FIG. 13, a plurality of light-emitting units 2 are formed on the base substrate 1. Each of the light-emitting units 2 includes a first electrode 201, a first semiconductor layer 202, a light-emitting layer 203, a second semiconductor layer 204, and a second electrode 205 which are stacked, where the first electrode 201 is located on a side of the second electrode 205 facing away from the base substrate 1, and the plurality of light-emitting units 2 share a common first electrode 201.

The display panel prepared by the method of preparing the display panel according to the present disclosure is the same as the display panel according to the above embodiments, and thus has the same beneficial effects as the display panel according to the above embodiments, which will not be repeated herein.

In an embodiment of the present disclosure, the above step S110 may include steps S1101A to S1104A.

At step S1101A, as shown in FIG. 2, a first semiconductor layer 202, a light-emitting layer 203, and a second semiconductor layer 204 are sequentially formed on a support plate 5.

According to the present disclosure, the first semiconductor layer 202, the light-emitting layer 203, and the second semiconductor layer 204 may be sequentially formed on the support plate 5 through an epitaxial growth process. The support plate 5 may be made of Si, but the present disclosure is not limited thereto.

At step S1102A, as shown in FIG. 3, a first etching trench 11 and a plurality of first retention units 12 arranged at intervals are formed by a patterning process, the first etching trench 11 being disposed around the first retention units 12.

The patterning process may be a photolithography process, or the like. A distance between a bottom surface of the first etching trench 11 and the support plate 5 may be equal to a thickness of the first semiconductor layer 202. That is, the sum of a thickness of the light-emitting layer 203 and a thickness of the second semiconductor layer 204 is equal to a depth of the first etching trench 11. However, the distance between the bottom surface of the first etching trench 11 and the support plate 5 may be greater than zero and less than the thickness of the first semiconductor layer 202. That is, the light-emitting layer 203 formed in step S1101A is over-etched in the present disclosure, which can ensure that the light-emitting layer 203 is completely etched in a thickness direction of the support plate 5, thereby simplifying the etching process. In other embodiments of the present disclosure, the bottom surface of the first etching trench 11 may be the support plate 5. For example, in the case that the distance between the bottom surface of the first etching trench 11 and the support plate 5 is greater than zero and less than or equal to the thickness of the first semiconductor layer 202, the plurality of first retention units 12 are arranged at intervals, and the first etching trench 11 is disposed around the first retention units 12, that is, each of the first retention units 12 retains a portion of the second semiconductor layer 204 and a portion of the light-emitting layer 203. The first semiconductor layers 202 may include a common film layer 2021 and a plurality of protrusions 2022. The plurality of protrusions 2022 are disposed one-to-one on surfaces of the plurality of light-emitting layers 203 facing away from the second semiconductor layer 204. The common film layer 2021 is disposed on a side of the plurality of protrusions 2022 facing away from the second semiconductor layer 204. A ratio of a thickness L2 of the protrusion 2022 to a thickness L1 of the common film layer 2021 is 1/4 to 1/2.

An orthographic projection of the first retention unit 12 onto the support plate 5 may be in the shape of a square, a rectangle, a circle, or the like. For example, in the case that an orthographic projection of the first retention unit 12 onto the support plate 5 is in the shape of a square, a side length of the square may be 5 µm, or the like. Further, the plurality of first retention units 12 arranged at intervals may be distributed in an array.

At step S1 103A, as shown in FIG. 4, the first retention unit 12 is bonded to the base substrate 1 via a metal bonding layer 15, and the support plate 5 is removed. The metal bonding layer 15 forms the second electrode 205.

For example, step S1 103A may include forming a first bonding layer on surfaces of the first retention units 12, forming a second bonding layer on the base substrate 1, and bonding the first bonding layer and the second bonding layer to form the metal bonding layer 15. The bonding process may adopt eutectic bonding or, of course, thermocompression bonding. In the eutectic bonding process, both the first bonding layer and the second bonding layer may be of a bimetallic layer structure, such as Cu/Sn or Au/In. In the thermocompression bonding process, both the first bonding layer and the second bonding layer may be of a monometallic layer structure, such as Au, Cu, or Al.

At step S1104A, as shown in FIG. 7, the first electrode 201 is formed.

The first electrode 201 may be formed by evaporation.

In another embodiment of the present disclosure, step S110 may include steps S1101B to S1104B.

At step S1 101B, as shown in FIG. 2, a first semiconductor layer 202, a light-emitting layer 203, and a second semiconductor layer 204 are sequentially formed on a support plate 5.

According to the present disclosure, the first semiconductor layer 202, the light-emitting layer 203, and the second semiconductor layer 204 may be sequentially formed on the support plate 5 through an epitaxial growth process. The support plate 5 may be made of Si, but the present disclosure is not limited thereto. The first semiconductor layer 202 may have a different conductivity type than the second semiconductor layer 204. For example, the first semiconductor layer 202 is an n-type semiconductor layer and the second semiconductor layer 204 is a p-type semiconductor layer. For another example, the first semiconductor layer 202 is a p-type semiconductor layer and the second semiconductor layer 204 is an n-type semiconductor layer. Both the first semiconductor layer 202 and the second semiconductor layer 204 may include GaN. The light-emitting layer 203 may be a quantum well layer.

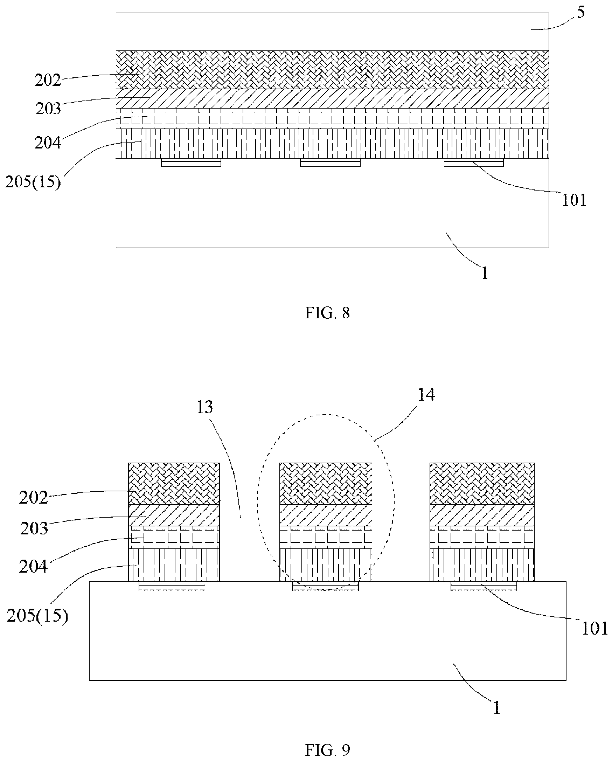

At step S1102B, as shown in FIG. 8, the second semiconductor layer 204 and the base substrate 1 are bonded via a metal bonding layer 15, which forms the second electrode 205.

For example, step S1 102B may include forming a first bonding layer on a surface of the second semiconductor layer 204, forming a second bonding layer on the base substrate 1, and bonding the first bonding layer and the second bonding layer to form the metal bonding layer 15. Both the first bonding layer and the second bonding layer may be of a bimetallic layer structure, such as Cu/Sn or Au/In. It should be noted that at step S1 102B, the first bonding layer covers an entire surface area of the second semiconductor layer 204, and the second bonding layer covers an entire surface area of the base substrate 1, such that the bonding strength can be improved.

At step S1103B, as shown in FIG. 9, the support plate 5 is removed, and a second etching trench 13 and a plurality of second retention units 14 arranged at intervals are formed by a patterning process. The second etching trench 13 is disposed around the second retention units 14, and a bottom surface of the second etching trench 13 is the base substrate 1.

For example, in the case that the support plate 5 is made of Si, the support plate 5 may be removed by an acidic etching solution such as HF (Hydrogen Fluoride) in the present disclosure. The patterning process may be a photolithography process or the like. The bottom surface of the second etching trench 13 may be the base substrate 1. That is, the sum of a thickness of the first semiconductor layer 202, a thickness of the light-emitting layer 203, a thickness of the second semiconductor layer 204, and a thickness of the metal bonding layer 15 is equal to a depth of the second etching trench 13. The plurality of second retention units 14 are arranged at intervals, and the second etching trench 13 is disposed around the second retention units 14. That is, each of the second retention units 14 retains a portion of the first semiconductor layer 202, a portion of the second semiconductor layer 204, a portion of the light-emitting layer 203, and a portion of the second electrode 205.

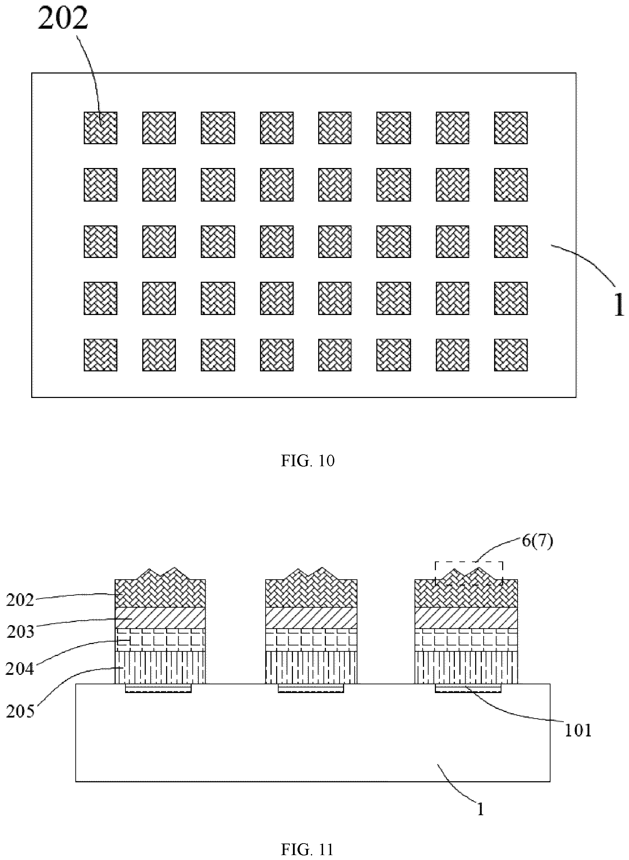

As shown in FIG. 10, an orthographic projection of the second retention unit 14 onto the base substrate 1 may be in the shape of a square, a rectangle, a circle, or the like. For example, in the case that an orthographic projection of the second retention unit 14 onto the base substrate 1 is in the shape of a square, a side length of the square may be 5 µm, or the like. Further, the plurality of second retention units 12 arranged at intervals may be distributed in an array. After step S1103B, the present disclosure may further include step S1104B of forming the first electrode 201 as shown in FIG. 13.

The method of preparing the display panel according to the present disclosure may further include forming the above-described isolation structure 3. For example, in the case that the isolation structure 3 is disposed between the base substrate 1 and the first electrode 201, as shown in FIG. 6, the isolation structure 3 may be formed after the above step S1103A and before the above step S1104A. However, as shown in FIG. 12, the isolation structure 3 may be formed after step S1103B and before step S1104B. As shown in FIG. 15 and FIG. 16, in the case that the isolation structure 3 is disposed on the side of the first electrode 201 facing away from the base substrate 1, for example, the isolation structure 3 may be formed after the formation of the first electrode 201. It should be noted that in FIGS. 15 and 16, an insulating layer 9 may be formed before the first electrode 201 is formed. The insulating layer 9 covers side surfaces of the first semiconductor layer 202, the light-emitting layer 203, the second semiconductor layer 204, and the second electrode 205, and is provided with a window exposing a top surface of the first semiconductor layer 202. The first electrode 201 is in contact with the first semiconductor layer 202 through the window.

The method of preparing the display panel according to the present disclosure may further include forming the above-described light extraction structure 7. For example, in the case that the first semiconductor layer 202 has the above-described roughened surface 6, as shown in FIGS. 5 and 11, the surface of the first semiconductor layer 202 may be roughened with an alkaline solution before the first electrode 201 is formed in the present disclosure, in order to form the roughened surface 6. For example, in the case that the first electrode 201 has the above-described roughened surface 6, as shown in FIG. 15, the surface of the first electrode 201 may be patterned through a photolithography process after the first electrode 201 is formed in the present disclosure, in order to form the roughened surface 6.

After forming the first electrode 201, as shown in FIG. 7 and FIG. 13, the method of preparing the display panel according to the present disclosure may further include forming the above-described metal grid 4 and connecting wire 8.

After forming the first electrode 201, as shown in FIG. 16, the method of preparing the display panel according to the present disclosure may further include forming the above-described light condenser unit 10. The light condenser unit 10 may be formed by dispensing adhesive.

Embodiments of the present disclosure further provide a display apparatus. The display apparatus may include the display panel according to any one of the above embodiments. Since the display panel in the display apparatus according to the embodiments of the present disclosure is the same as the display panel according to the above embodiments, it has the same beneficial effects as the display panel according to the above embodiments, which will not be repeated herein.

The foregoing are merely preferred embodiments of the present disclosure, and are not intended to limit the present disclosure in any form. Although the present disclosure has been disclosed as above in the preferred embodiments, they are not intended to limit the present disclosure. Any person of skill in the art, without departing from the scope of the technical solutions of the present disclosure, may make some changes or modifications into equivalent embodiments with equivalent changes by using the above disclosed technical contents. Any simple variations, equivalent changes and modifications made to the above embodiments based on the technical essence of the present disclosure, without deviating from the contents of the technical solutions of the present disclosure, still fall within the scope of the technical solutions of the present disclosure.

## Claims

1. A display panel, comprising:
a base substrate; and
a plurality of light-emitting units provided on the base substrate,
wherein each of the light-emitting units comprises a first electrode, a first semiconductor layer, a light-emitting layer, a second semiconductor layer, and a second electrode which are stacked, and
wherein the first electrode is provided on a side of the second electrode facing away from the base substrate, and the plurality of light-emitting units share a common first electrode.

2. The display panel according to claim 1, further comprising:
an isolation structure, at least part of the isolation structure being located between adjacent two of the light-emitting units, and a surface of the isolation structure facing away from the base substrate being further away than a surface of each light-emitting layer facing away from the base substrate in a thickness direction of the base substrate.

3. The display panel according to claim 2, wherein
the isolation structure is provided on the base substrate and comprises a plurality of openings, and the plurality of light-emitting units are provided one-to-one in the plurality of openings, and
the first electrode is provided on a side of the isolation structure facing away from the base substrate.

4. The display panel according to claim 3, wherein
the first semiconductor layers of the plurality of light-emitting units are arranged in a same layer and are of a monolithic structure, and
the first semiconductor layers are provided on the surface of the isolation structure facing away from the base substrate.

5. The display panel according to claim 4, wherein a refractive index of the isolation structure is the same as that of the first semiconductor layers.

6. The display panel according to claim 2, wherein
a spacing area is between portions of adjacent two of the light-emitting units other than the first electrode, and a recess is formed in a portion of the first electrode corresponding to the spacing area, and
the isolation structure is provided on a side of the first electrode facing away from the base substrate, and located in the recess.

7. The display panel according to claim 2, wherein the isolation structure comprises a retro-reflective material.

8. The display panel according to claim 1, wherein the second electrode is bonded to the base substrate via a metal bonding layer.

9. The display panel according to any one of claims 1 to 8, further comprising:
a light extraction structure provided on a light-exiting side of the light-emitting layer.

10. The display panel according to claim 9, wherein
a surface of the first electrode facing away from the base substrate is a roughened surface that forms the light extraction structure; or
a surface of the first semiconductor layer facing away from the second semiconductor layer is a roughened surface that forms the light extraction structure.

11. The display panel according to any one of claims 1 to 8, further comprising:
a light condenser unit provided on the first electrode in an area corresponding to the light-emitting layer.

12. The display panel according to claim 11, wherein a surface of the light condenser unit facing away from the first electrode is a curved surface, and protrudes towards a direction away from the base substrate.

13. The display panel according to claim 4, wherein the first semiconductor layers comprise a common film layer and a plurality of protrusions, wherein the plurality of protrusions are provided one-to-one on surfaces of the light-emitting layers of the plurality of light-emitting units facing away from the second semiconductor layer, and the common film layer is provided on a side of the plurality of protrusions facing away from the second semiconductor layer.

14. The display panel according to claim 13, wherein a ratio of a thickness of each of the protrusions to a thickness of the common film layer is 1/4 to 1/2.

15. The display panel according to claim 1, further comprising:
a metal grid provided on a side of the first electrode facing away from the base substrate and connected with the first electrode, wherein an orthographic projection of each light-emitting layer onto the base substrate is located within an area of an orthographic projection of a respective hole of the metal grid onto the base substrate.

16. The display panel according to claim 15, wherein
the display panel comprises a display area and a peripheral area surrounding the display area, the plurality of light-emitting units being located in the display area, and
the display panel further comprises:
a connecting wire provided on the base substrate and located in the peripheral area, wherein the metal grid is electrically connected with the connecting wire.

17. The display panel according to claim 1, wherein the base substrate is a silicon-based substrate.

18. A method of preparing a display panel, comprising:
providing a base substrate; and
forming a plurality of light-emitting units on the base substrate,
wherein each of the light-emitting units comprises a first electrode, a first semiconductor layer, a light-emitting layer, a second semiconductor layer, and a second electrode which are stacked, and
wherein the first electrode is provided on a side of the second electrode facing away from the base substrate, and the plurality of light-emitting units share a common first electrode.

19. The method according to claim 18, further comprising:
forming an isolation structure, wherein at least part of the isolation structure is located between adjacent two of the light-emitting units, and a surface of the isolation structure facing away from the base substrate is further away than a surface of each light-emitting layer facing away from the base substrate in a thickness direction of the base substrate.

20. The method according to claim 19, wherein
the isolation structure is provided on the base substrate and comprises a plurality of openings, and the plurality of light-emitting units are provided one-to-one in the plurality of openings, and
the first electrode is formed on a side of the isolation structure facing away from the base substrate.

21. The method according to claim 18, wherein forming the plurality of light-emitting units on the base substrate comprises:
sequentially forming the first semiconductor layer, the light-emitting layer, and the second semiconductor layer on a support plate;
forming a first etching trench and a plurality of first retention units arranged at intervals by a patterning process, wherein the first etching trench is disposed around the first retention units, and a distance between a bottom surface of the first etching trench and the support plate is less than or equal to a thickness of the first semiconductor layer;
bonding the first retention units and the base substrate via a metal bonding layer that forms the second electrode, and removing the support plate; and
forming the first electrode.

22. The method according to claim 21, wherein
the distance between the bottom surface of the first etching trench and the support plate is greater than zero and less than the thickness of the first semiconductor layer, and
the first semiconductor layers comprise a common film layer and a plurality of protrusions, wherein the plurality of protrusions are provided one-to-one on surfaces of the light-emitting layers of the plurality of light-emitting units facing away from the second semiconductor layer, and the common film layer is provided on a side of the plurality of protrusions facing away from the second semiconductor layer.

23. The method according to claim 18, wherein forming the plurality of light-emitting units on the base substrate comprises:
sequentially forming the first semiconductor layer, the light-emitting layer, and the second semiconductor layer on a support plate;
bonding the second semiconductor layer and the base substrate via a metal bonding layer that forms the second electrode;
removing the support plate and forming a second etching trench and a plurality of second retention units arranged at intervals by a patterning process, wherein the second etching trench is disposed around the second retention units, and a bottom surface of the second etching trench is the base substrate; and
forming the first electrode.

24. A display apparatus, comprising the display panel according to any one of claims 1 to 17.
